# EUROPÄISCHE PATENTSCHRIFT

(11) **EP 3 170 229 B1**
(45) Veröffentlichungstag und Bekanntmachung des Hinweises auf die Patenterteilung: **17.02.2021**
(21) Anmeldenummer: 15748164.9
(22) Anmeldetag: 01.07.2015
(51) Int. Cl.: H01R 13/6471, H01R 13/6473, H01R 13/66, H05K 1/02

(54) **STECKVERBINDER UND BAUELEMENT UND VERWENDUNG DES STECKVERBINDERS**
PLUG CONNECTOR AND COMPONENT AND USE OF THE PLUG CONNECTOR
CONNECTEUR ET COMPOSANT ET UTILISATION DU CONNECTEUR

(30) Priorität: 14.07.2014 DE 102014109867
(43) Veröffentlichungstag der Anmeldung: 24.05.2017
(73) Patentinhaber: ERNI Production GmbH & Co. KG, 73099 Adelberg (DE)
(72) Erfinder: MÖDINGER, Roland, 71384 Weinstadt (DE); MOLITOR, Stefan, 73116 Wäschenbeuren (DE); LAPPÖHN, Jürgen, 73108 Gammelshausen (DE); GNEITING, Thomas, 72636 Frickenhausen (DE)
(74) Vertreter: Jakelski & Althoff Patentanwälte PartG mbB
(86) Internationale Anmeldenummer: PCT/DE2015/100275
(87) Internationale Veröffentlichungsnummer: WO 2016/008473

(56) Entgegenhaltungen:
- JP-A- H0 256 878
- US-A1- 2003 087 559
- US-A1- 2012 184 115
- US-B1- 6 302 741
- US-B1- 7 928 608
- US-B2- 6 899 566

## Beschreibung

Die Erfindung geht aus von einem Steckverbinder und einem Bauelement mit einer elektrischen Schaltungsmasse nach der Gattung des unabhängigen Vorrichtungsanspruchs.

Die Erfindung betrifft weiterhin eine Verwendung des erfindungsgemäßen Steckverbinders und des Bauelements.

### Stand der Technik

Die Offenlegungsschrift DE 197 27 092 A1 beschreibt einen abgeschirmten elektrischen Steckverbinder, der Abschirmlaschen enthält. Die Abschirmlaschen sind in mehreren Gruppen angeordnet, wodurch eine Vielzahl von Leitungsführungen entsteht, die an eine elektrische Schaltungsmasse einer Leiterplatte angeschlossen werden können. Aufgrund der speziellen Ausgestaltung wird eine niederinduktive Anbindung der Abschirmung an die elektrische Schaltungsmasse erhalten, wodurch die Wirksamkeit der Abschirmung bei höheren Signalfrequenzen optimiert wird.

Die Offenlegungsschrift DE 10 2008 006 340 A1 beschriebt einen Steckverbinder mit einem aufgeformten Abschirmgehäuse. Ein erster abisolierter Kabelabschnitt ist mit einem Klemmelement beispielsweise mittels Crimpens kontaktiert. Der entsprechende Kabelabschnitt ist über eine Abschirmung zudem mit einer Erdungsschiene kontaktiert. Die Erdungsschiene ist vorzugsweise aus einem Material mit geringer elektrischer Impedanz ausgebildet, um eine Steuerung des Erdungswiderstands für die Abschirmung zu ermöglichen. Ein leitfähiges Steckverbinder-Dichtungselement verschließt mögliche Leckstromwege für Hochfrequenzstörungen und reduziert die Impedanz einer Verbindung zwischen der Abschirmung und der elektrischen Schaltungsmasse. Hierbei ist die Verbindung zwischen der Abschirmung und der elektrischen Schaltungsmasse bzw. der Erdungsschiene mit einer möglichst geringen Impedanz realisiert, um eine wirkungsvolle Abschirmung bis zu hohen Frequenzen sicherzustellen.

Die Offenlegungsschrift DE 42 22 452 A1 beschreibt einen abgeschirmten Steckverbinder. Die relativ dünnen und auf ihrer Kante stehenden eingesetzten Masse- und Abschirmkontakte bilden eine Verbindung, die sich in eine leitende Abschirm- und Masseschicht des eingesteckten Steckverbinders einbeißt und so eine stabile elektrische Verbindung der Abschirm- und Masseleitungen mit möglichst geringer Impedanz bildet.

Die Gebrauchsmusterschrift DE 93 12 470 U1 betrifft einen koaxialen Steckverbinder. Der bekannte Steckverbinder bietet die Möglichkeit in einer Antennensteckdose einen Abschlusswiderstand automatisch an- und abzuschalten, der dann zwischen Mittenleiter, also einem Signal-Kontaktelement, und einer Außenhülse gegen die elektrische Schaltungsmasse eingeschleift wird, wenn kein komplementärer Steckverbinder in den Steckverbinder eingeführt ist. Der Wert des Abschlusswiderstands soll dem Wellenwiderstand der Antennenleitung entsprechen.

In der Offenlegungsschrift DE 101 19 695 A1 ist ein Steckverbinder beschrieben, bei welchem die beiden Steckverbindungselemente des Steckverbinders jeweils mit Abschirmblechen versehen sind. Die Abschirmbleche liegen im kontaktierten Zustand der beiden Steckverbindungselemente im Wesentlichen vollflächig aneinander, wodurch ein niederinduktiver und insgesamt niederohmiger Abschirm-Signalpfad erreicht wird.

In der Patentschrift US 6 976 886 B2 ist ein Steckverbinder beschrieben, bei dem durch eine spezielle Anordnung und Ausrichtung der signal-führenden und abschirm- beziehungsweise massepotenzial-führenden Kontaktelementen zueinander eine hohe Abschirmwirkung der signal-führenden Leitungen gegeneinander und des Steckverbinders insgesamt erreicht werden soll. Der bekannte Steckverbinder ist speziell für hochfrequente Signale geeignet, wobei die Anordnung der signal-führenden und massepotenzial-führenden Kontaktelemente darüber hinaus zur Erzielung eines bestimmten Wellenwiderstands speziell vorgegeben ist.

In der Offenlegungsschrift DE 198 07 713 A1 ist ein Steckverbinder beschrieben, der eine große Anzahl von Kontaktelementen enthält. Der bekannte Steckverbinder ist zum Herstellen von Steckverbindungen zwischen Backplanes und Einschubkarten vorgesehen, wobei im konkreten Ausführungsbeispiel Steckverbindungen zwischen Backplanes und Einschubkarten sogenannter Compact-PCI-Systeme hergestellt werden.

In dem Fachbuch von Meinke und Gundlach "Taschenbuch für Hochfrequenztechnik", Springer-Verlag 1956, sind Grundbegriffe der Elektrotechnik wie Kapazität, Induktivität und Wellenwiderstand erläutert

US 6 899 566 B2 offenbart die Präambel des Anspruchs 1.

Der Erfindung liegt die Aufgabe zugrunde, einen Steckverbinder anzugeben, der mit einfachen Mitteln eine hohe Unterdrückung von Störsignalen ermöglicht.

Die Aufgabe wird durch die im unabhängigen Vorrichtungsanspruch angegebenen Merkmale gelöst.

### Vorteile der Erfindung

Die Erfindung betrifft zunächst einen Steckverbinder nach Anspruch 1.

Der erfindungsgemäßen Steckverbinder mit dem Bauelement eignet sich insbesondere zur Verbindung von Signalleitungen, über welche hochfrequente Signale, beispielsweise digitale differenzielle Signale übertragen, deren Datenrate im Bereich beispielsweise bis 20 Gigabit/Sekunde liegen kann. Entsprechend kann die Grundfrequenz der Signalfrequenz im Bereich bis 20 Gigahertz liegen.

Die erfindungsgemäß vorgesehene Maßnahme, nämlich die elektrische Anbindung des wenigstens einen Abschirm-Kontaktelements des Steckverbinders an eine Schaltungsmasse über einen ohmschen Widerstand anstelle einer unmittelbaren elektrischen Verbindung vermeidet parasitäre Schwingungen. Derartige parasitäre Schwingungen, welche das Signal-Übertragungsverhalten über den Steckverbinder nachteilig beeinflussen und die Signalqualität erheblich verschlechtern, können auftreten, wenn die Bauhöhe des Steckverbinders, der mit der elektrischen Schaltungsmasse, welches das Bauelement bereitstellt, direkt verlötet ist, im Bereich der halben Wellenlänge der parasitären Schwingungen liegt. Der erfindungsgemäß vorgesehene, zwischen einem Abschirm-Kontaktelement und der elektrischen Schaltungsmasse eingefügte ohmsche Widerstand wirkt offensichtlich als Dämpfungswiderstand und verhindert derartige parasitäre Schwingungen bereits im Entstehen.

Vorteilhafte Weiterbildungen und Ausgestaltungen des erfindungsgemäßen Steckverbinders und des Bauelements sind jeweils Gegenstände von abhängigen Vorrichtungsansprüchen.

Eine erste Ausgestaltung sieht vor, dass der Widerstandswert des ohmschen Widerstands dem Wellenwiderstand einer über den Steckverbinder (10) geführten Signalleitung entspricht. Experimentell und rechnerisch wurde festgestellt, dass mit dieser Bemessung des Widerstandswerts eine optimale Unterdrückung von parasitären Schwingungen erzielt wird. Gemäß einer Ausgestaltung kann der Widerstandswert des ohmschen Widerstands generell in einem Bereich von 20 - 100 Ohm liegen, wobei gemäß einer speziellen Ausgestaltung der Widerstandswert des ohmschen Widerstands bei wenigstens näherungsweise 50 Ohm liegen kann.

Eine andere Ausgestaltung sieht vor, dass ein derartiger ohmscher Widerstand jeweils genau einem Abschirm-Kontaktelement zugeordnet ist. Eine hierzu alternative Ausgestaltung, welche die erforderliche Anzahl von ohmschen Widerständen reduziert, sieht vor, dass ein ohmscher Widerstand mehreren Abschirm-Kontaktelementen zugeordnet ist, wobei die Abschirm-Kontaktelemente in diesem Fall elektrisch unmittelbar miteinander verbunden sind.

Der wenigstens eine ohmsche Widerstand kann bereits unmittelbar im Steckverbinder angeordnet sein. Alternativ kann der wenigstens eine ohmsche Widerstand dem Bauelement zugeordnet sein. Rein prinzipiell könnte auch eine Aufteilung des ohmschen Widerstands vorgesehen sein, bei welcher ein Teil des ohmschen Widerstands innerhalb des Steckverbinders und ein Teil des ohmschen Widerstands auf dem Bauelement angeordnet ist. Rein prinzipiell kann auch eine freie Verdrahtung des ohmschen Widerstands vorgesehen sein, bei welcher der ohmsche Widerstand weder unmittelbar innerhalb des Steckverbinders noch unmittelbar auf oder in dem Bauelement angeordnet ist.

Eine besonders vorteilhafte Ausgestaltung sieht vor, dass der Steckverbinder von wenigstens einer Abschirmung umgeben ist, wobei die Abschirmung vorzugsweise unmittelbar mit der elektrischen Schaltungsmasse verbunden ist. Die Abschirmung verhindert wirkungsvoll die Abstrahlung von Störsignalen vom Steckverbinder und unterdrückt entsprechend weitgehend die Einkopplung von externen Störsignalen in den Steckverbinder. Die wenigstens eine Abschirmung leistet einen Beitrag zum Unterdrücken der gegebenenfalls auftretenden parasitären Schwingungen.

Eine Weiterbildung sieht vor, dass das Bauelement eine Leiterplatte ist. Insbesondere kann die Leiterplatte eine Backplane-Leiterplatte sein, welche zur Aufnahme von Einschubkarten vorgesehen ist.

Eine andere Ausgestaltung sieht vor, dass die Leiterplatte eine Multilayer-Leiterplatte ist und dass eine Ebene der Multilayer-Leiterplatte zumindest teilweise eine elektrisch leitfähige Fläche mit dem Potenzial der elektrischen Schaltungsmasse aufweist. Mit dieser Maßnahme wird eine einfache Realisierung der elektrischen Schaltungsmasse möglich, wobei die flächige Ausgestaltung der Schaltungsmasse gleichzeitig eine Abschirmwirkung bereitstellt.

Eine Weiterbildung sieht vor, dass ein zum Steckverbinder korrespondierender Steckverbinder vorgesehen ist, der Kontaktelemente aufweist, die in wenigstens ein Signal-Kontaktelement und wenigstens ein Abschirm-Kontaktelement aufgeteilt sind. Weiterhin ist ein zweites Bauelement mit einer zweiten elektrischen Schaltungsmasse vorgesehen. Hierbei ist ein korrespondierendes Abschirm-Kontaktelement des korrespondierenden Steckverbinders über einen elektrischen Widerstand mit einer zweiten elektrischen Schaltungsmasse verbunden. Es hat sich herausgestellt, dass mit dieser Maßnahme, welche auf beiden Seiten der Steckverbindung vorgesehen ist, eine weitere Verbesserung bei der Unterdrückung von parasitären Schwingungen erzielt wird.

Hierzu trägt auch eine weitere vorteilhafte Ausgestaltung bei, welche vorsieht, dass bei miteinander kontaktierten Steckverbinder die elektrische Schaltungsmasse, die dem Steckverbinder zugeordnet ist und eine zweite elektrische Schaltungsmasse, welche dem korrespondierenden Steckverbinder zugeordnet ist, unmittelbar elektrisch miteinander verbunden sind. Der Potenzialausgleich wird vorzugsweise über Kontaktelemente innerhalb der beiden Steckverbinder hergestellt.

Eine bevorzugte Verwendung des Steckverbinders und des Bauelements bzw. des korrespondierenden Steckverbinders und des zweiten Bauelements ist damit gegeben, dass benachbarte Kontaktelemente ein Signal-Kontaktelementpaar bilden, wobei dem Signal-Kontaktelementpaar wenigstens ein Abschirm-Kontaktelement zugeordnet ist. Diese Verwendung des erfindungsgemäßen Steckverbinders und des Bauelements ist besonders geeignet zum Verbinden von signalführenden Leitungen, welche differenzielle Signalen führen.

### Kurzbeschreibung der Ausführungsbeispiele

Die Ausführungsbeispiele werden anhand der Zeichnung näher erläutert.
Figur 1 zeigt schematisch eine Draufsicht auf ein Layout eines Steckverbinders,
Figur 2 zeigt den Steckverbinder vor der Kontaktierung mit einem Bauelement und einen korrespondierenden Steckverbinder im zusammengesteckten Zustand,
Figur 3 zeigt die in Figur 2 gezeigte Anordnung, bei welcher der korrespondierende Steckverbinder vor der Kontaktierung mit einem zweiten Bauelement dargestellt ist,
Figur 4 zeigt ein alternatives Ausführungsbeispiel der die in Figur 2 gezeigten Anordnung und
Figur 5 zeigt ein alternatives Ausführungsbeispiel der in Figur 3 gezeigten Anordnung.

### Detaillierte Beschreibung der Ausführungsbeispiele

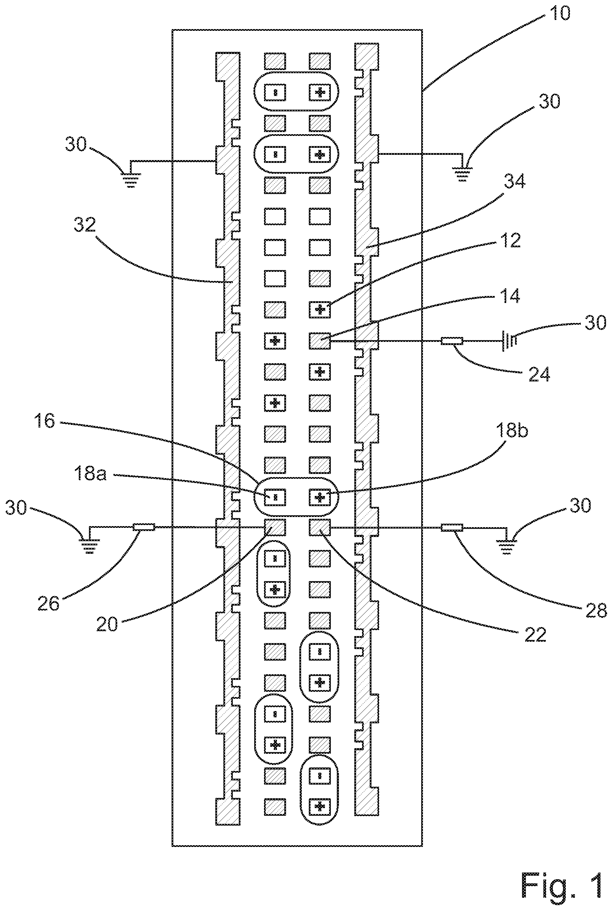

Figur 1 zeigt schematisch eine Draufsicht auf ein Layout eines Steckverbinders 10, der wenigstens zwei Kontaktelemente, bevorzugt jedoch eine Vielzahl von Kontaktelementen aufweist. Die Kontaktelemente sind eingeteilt in wenigstens ein Signal-Kontaktelement und wenigstens ein Abschirm-Kontaktelement. Beispielsweise kann ein Signal-Kontaktelement 12 vorgesehen sein, das benachbart zu einem Abschirm-Kontaktelement 14 angeordnet ist.

Bei der in Figur 1 gezeigten Darstellung soll ein Symbol, wie beispielsweise ein Plus-Zeichen, ein Signal-Kontaktelement 12 und eine Schraffur ein Abschirm-Kontaktelement 14 kennzeichnen.

Das gezeigte Signal-Kontaktelement 12 und das benachbarte Abschirm-Kontaktelement 14 sind zum Verbinden einer nicht gezeigten signalführenden Leitung vorgesehen, wobei die signalführende Leitung eine am Signal-Kontaktelement 12 angeschlossene Signalleitung sowie eine am Abschirm-Kontaktelement 14 angeschlossene Abschirmleitung aufweisen kann.

Der Steckverbinder 10 kann bevorzugt zum Verbinden von signalführenden Leitungen verwendet werden, die zumindest ein Paar von signalführenden Leitungen enthält, die mit einem Signal-Kontaktelementpaar 16 verbunden sind, das zwei unmittelbar benachbart angeordnete Signal-Kontaktelemente 18a, 18b umfasst. Das Signal-Kontaktelementpaar 16 wird bevorzugt zum Verbinden von differenziellen Signalen verwendet, die in Figur 1 mit einem Plus-Symbol und mit einem Minus-Symbol gekennzeichnet sind. Ein solches differenzielles Signal weist in Bezug auf einen Mittenpegel an dem einem Signal-Kontaktelement (Plus), beispielsweise einen positiven und am benachbarten Signal-Kontaktelement (Minus) des Signal-Kontaktelementpaars 16 gleichzeitig einen negativen Pegel auf. Die Pegel wechseln sich im Gegentakt mit der Signalfrequenz ab.

Die mit dem Signal-Kontaktelementpaar 16 verbundene, nicht gezeigte signalführende Leitung enthält wenigstens eine Abschirmleitung, wobei im gezeigten Ausführungsbeispiel zwei Abschirm-Leitungen vorgesehen sein sollen, die mit jeweils einem Abschirm-Kontaktelement 20, 22 verbunden sein sollen. Die Abschirm-Kontaktelemente 20, 22 sind vorzugsweise in Bezug auf das zugehörende Signal-Kontaktelementpaar 16 unmittelbar benachbart angeordnet, um die beste Abschirmwirkung zu erzielen.

Erfindungsgemäß ist vorgesehen, dass wenigstens ein Abschirm-Kontaktelement 14, 20, 22 nicht unmittelbar, sondern über einen ohmschen Widerstand. 24, 26, 28 mit einer ersten elektrischen Schaltungsmasse 30 verbunden ist. Im gezeigten Ausführungsbeispiel sind, neben dem einen Abschirm-Kontaktelement 14, auch die dem Signal-Kontaktelementpaar 16 zugeordneten Abschirm-Kontaktelemente 20, 22 jeweils über einen ohmschen Widerstand 26, 28 mit der ersten elektrischen Schaltungsmasse 30 verbunden.

Es wird darauf hingewiesen, dass nicht jedes Abschirm-Kontaktelement 14, 26, 28 des Steckverbinders 10 über einen ohmschen Widerstand mit der elektrischen Schaltungsmasse 30 verbunden sein muss, sondern auch unmittelbar mit der ersten elektrischen Schaltungsmasse 30 verbunden sein kann.

Die erste elektrische Schaltungsmasse 30 ist auf einem in Figur 1 nicht näher gezeigten ersten Bauelement vorhanden, mit welchem der Steckverbinder 10 entweder bereits verlötet ist oder im Rahmen eines Bestückungsprozesses noch verlötet wird.

Der ohmsche Widerstand 24, 26, 28 kann innerhalb des Steckverbinders 10 angeordnet sein. Alternativ oder zusätzlich kann der ohmsche Widerstand 24, 26, 28 auch auf dem ersten Bauelement angeordnet sein.

Vorzugsweise werden über den Steckverbinder 10 hochfrequente Signale, beispielsweise digitale differenzielle Signale übertragen, deren Datenrate im Bereich beispielsweise bis 20 Gigabit/Sekunde liegen kann. K, entsprechend einer Grundfrequenz von 20 Gigahertz.

Anhand von Untersuchungen an konkreten Steckverbindungen, die mit sehr hohen Datenraten beaufschlagt wurden, hat sich gezeigt, dass bei einer direkten Kontaktierung des Abschirm-Kontaktelements 14, 20, 22 mit der ersten elektrischen Schaltungsmasse 30 parasitäre Schwingungen auftreten können, die beispielsweise im Frequenzbereich von 17 - 18 Gigahertz liegen. Eine derartige Resonanzstelle in einer Steckverbindung kann das Signal-Übertragungsverhalten über den Steckverbinder 10 nachteilig beeinflussen.

Die unerwünschte Resonanz kann auf die Länge des Signalpfades im Steckverbinder 10 zurückgeführt werden. Die bereits genannte Resonanzfrequenz im Bereich von ungefähr 17 - 18 Gigahertz entspricht einer Wellenlänge von ungefähr 10 Millimetern unter der Annahme, dass die effektive relative Dielektrizitätskonstante ungefähr 2,8 beträgt. Die für den Steckverbinder 10 verwendeten Kunststoffe können eine solche Dielektrizitätskonstante aufweisen. Bei einer angenommenen Bauhöhe des Steckverbinders 10 von 5 Millimetern entspricht die Bauhöhe wenigstens näherungsweise der halben Wellenlänge und kann deshalb das Auftreten der Resonanz erklären.

Die parasitären Schwingungen beeinflussen nicht nur das Signal-Übertragungsverhalten über das betroffene Signal-Kontaktelement 12, 18a, 18b, sondern auch benachbarte Signal-Kontaktelemente aufgrund der elektromagnetischen Ausbreitung innerhalb des Steckverbinders 10 und sollten deshalb auch aus diesem Grund vermieden werden.

Rechnerisch und experimentell wurde gefunden, dass der erfindungsgemäße ohmsche Widerstand 24, 26, 28, der zwischen dem Abschirm-Kontaktelement 14, 20, 22 und der ersten elektrischen Schaltungsmasse 30 eingefügt ist, als Dämpfungswiderstand wirkt und die Energie der elektrischen Schwingung bei der Resonanzfrequenz bereits im Entstehen weitgehend vernichtet, sodass sich die störende Resonanzfrequenz nicht ausbilden kann.

Der Widerstandswert des ohmschen Widerstands 24, 26, 28 liegt vorzugsweise im Bereich zwischen 20 - 100 Ohm. Gemäß einem speziellen Ausführungsbeispiel kann der Widerstandswert des ohmschen Widerstands 24, 26, 28 wenigstens näherungsweise 50 Ohm betragen. Insbesondere ist ein Widerstandswert des ohmschen Widerstands 24, 26, 28 geeignet, der dem Wellenwiderstand der über den Steckverbinder 10 geführten Signalleitung entspricht. Einzelheiten zur Ermittlung des Kapazitätsbelags und des Induktivitätsbelags des Steckverbinders 10 sowie des Wellenwiderstands können aus dem eingangs angegebenen Fachbuch von Meinke und Gundlach, insbesondere den Seiten 14, 18 und 165 entnommen werden.

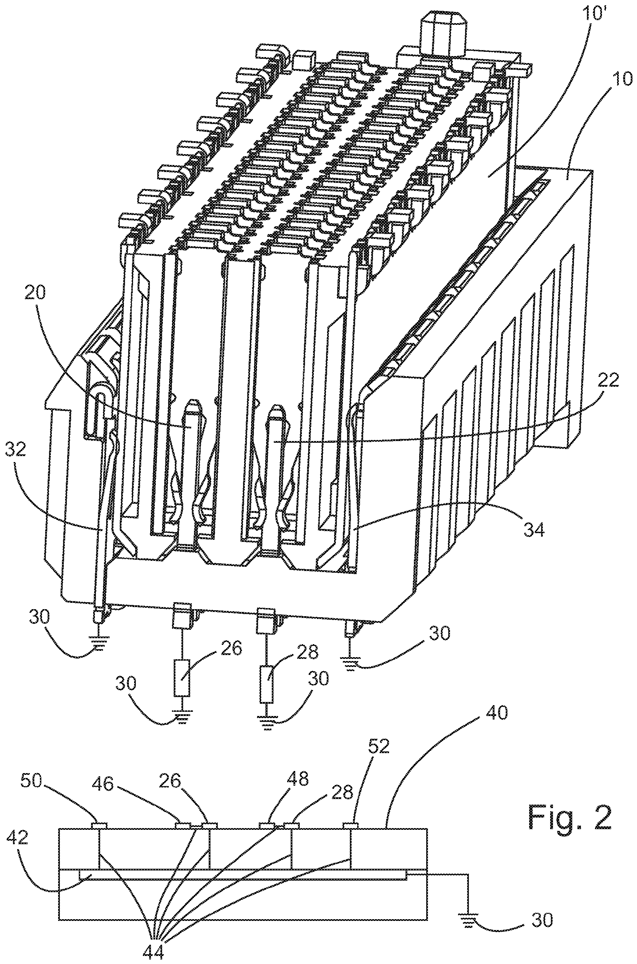

Der Steckverbinder 10 weist vorzugsweise eine Abschirmung 32, 34 auf, die unmittelbar mit der ersten elektrischen Schaltungsmasse 30 verbunden ist. Im gezeigten Ausführungsbeispiel wird exemplarisch davon ausgegangen, dass der Steckverbinder 10 auf beiden Seiten eine derartige Abschirmung 32, 34 aufweist und dass beide Abschirmungen 32, 34 mit der ersten elektrischen Schaltungsmasse 30 unmittelbar verbunden sind. Figur 2 zeigt, neben dem in Figur 1 gezeigten Steckverbinder 10, ein Ausführungsbeispiel des ersten Bauelements 40, das beispielsweise eine Platine ist, mit welcher der Steckverbinder 10 während eines Bestückungsvorgangs kontaktiert wird. Die erste elektrische Schaltungsmasse 30 ist dem ersten Bauelement 40 zugeordnet.

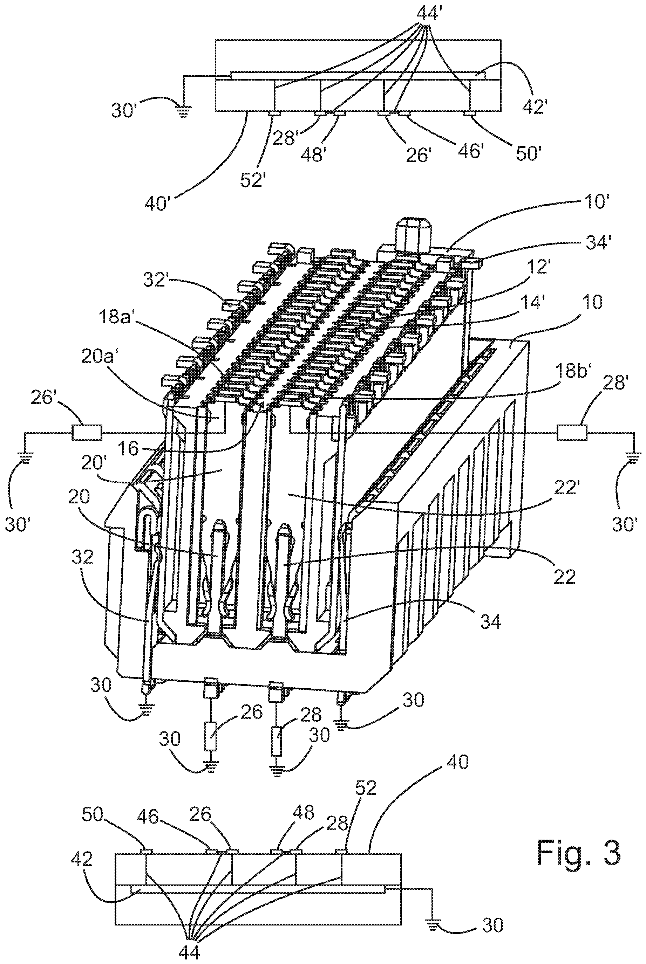

Diejenigen in Figur 2 gezeigten Komponenten, die mit den in Figur 1 gezeigten Komponenten übereinstimmen, sind jeweils mit denselben Bezugszeichen versehen. Diese Vereinbarung gilt auch für die nachfolgenden Figuren 3 - 5.

Gemäß Figur 2 kann die Leiterplatte als Ausführungsbeispiel des ersten Bauelements 40 beispielsweise als Multilayer-Leiterplatte realisiert sein. Hierbei kann die erste elektrische Schaltungsmasse 30 auf einer der Ebenen der Multilayer-Leiterplatte vorzugsweise als elektrisch leitende Fläche 42 realisiert sein, sodass die erste elektrische Schaltungsmasse 30 zugleich eine Abschirmwirkung aufweist.

Sofern der ohmsche Widerstand 24, 26, 28 außerhalb des Steckverbinders 10 auf dem ersten Bauelement 40 angeordnet sein soll, wird der ohmsche Widerstand 24, 26, 28 vorzugsweise auf der obersten Ebene der Leiterplatte positioniert und über möglichst kurze Verbindungsleitungen 44 einerseits mit Kontaktflächen 46, 48 und andererseits mit der ersten elektrischen Schaltungsmasse 30 verbunden.

Im gezeigten Ausführungsbeispiel sind auch die beiden Abschirmungen 32, 34 des Steckverbinders 10 mit Kontaktflächen 50, 52 zu kontaktieren oder sind bereits kontaktiert, wobei auch die Kontaktflächen 50, 52 vorzugsweise auf kürzest möglichem Weg über Verbindungsleitungen 44 mit der ersten elektrischen Schaltungsmasse 30 verbunden sind.

Bei dem in Figur 2 gezeigten Ausführungsbeispiel ist ein zum Steckverbinder 10 korrespondierender Steckverbinder 10' gezeigt, der in dem in den Steckverbinder 10 eingesteckten Zustand dargestellt ist.

Figur 3 zeigt ein Ausführungsbeispiel, gemäß welchem auch dem korrespondierenden Steckverbinder 10' ein zweites Bauelement 40', vorzugsweise ebenfalls eine Leiterplatte, zugeordnet sein kann. Das zweite Bauelement 40' kann wieder als Multilayer-Leiterplatte realisiert sein. Figur 3 zeigt auch hier einen Zustand, bei welchem der korrespondierende Steckverbinder 10' noch nicht mit dem zweiten Bauelement 40' beispielsweise mittels Lötens kontaktiert ist.

Der korrespondierende Steckverbinder 10' soll wenigstens ein korrespondierendes-Kontaktelement 12' und ein korrespondierendes Abschirm-Kontaktelement 14' enthalten. Vorzugsweise enthält der korrespondierende Steckverbinder 10' jedoch eine Vielzahl von Kontaktelementen, darunter wenigstens ein korrespondierendes Signal-Kontaktelementpaar 16', das korrespondierende Signal-Kontaktelemente 18a', 18b' enthält, das benachbart zu wenigstens einem korrespondierenden Abschirm-Kontaktelement 20', 22' positioniert ist.

Auch bei dem korrespondierenden Steckverbinder 10' ist das mindestens eine korrespondierende Abschirm-Kontaktelement 14', 20', 22' nicht unmittelbar mit einer zweiten elektrischen Schaltungsmasse 30', sondern ebenfalls über jeweils einen ohmschen Widerstand 26', 28' mit der zweiten elektrischen Schaltungsmasse 30' verbunden. Die zweite elektrische Schaltungsmasse 30' ist in diesem Fall dem zweiten Bauelement 40' zugeordnet.

Auch bei diesem Ausführungsbeispiel kann vorgesehen sein, dass der ohmsche Widerstand 26', 28' innerhalb des zweiten Steckverbinders 10' angeordnet ist. Vorzugsweise ist jedoch auch bei diesem Ausführungsbeispiel der ohmsche Widerstand 26', 28' auf dem zweiten Bauelement 40' vorgesehen.

Bei einer Realisierung des zweiten Bauelements 40' als Multilayer-Leiterplatte kann die zweite elektrische Schaltungsmasse 30' wieder auf einer separaten Ebene der Multilayer-Platine als größere elektrisch leitfähige Fläche 42' ausgebildet sein, um auch im zweiten Bauelement 40' eine Abschirmwirkung zu erzielen.

Sofern der ohmsche Widerstand 24, 26, 28 außerhalb des korrespondierenden Steckverbinders 10' auf dem zweiten Bauelement 40' angeordnet sein soll, wird der ohmsche Widerstand 24', 26', 28' vorzugsweise wieder auf der obersten Ebene der Leiterplatte positioniert und mit möglichst kurzen Verbindungsleitungen 44' einerseits mit Kontaktflächen 46', 48' und andererseits mit der zweiten elektrischen Schaltungsmasse 30' verbunden.

Gemäß dem gezeigten Ausführungsbeispiel kann auch der korrespondierende Steckverbinder 10' entsprechende Abschirmungen 32', 34' aufweisen, die mit Kontaktflächen 50', 52' auf dem zweiten Bauelement 40' zu kontaktieren oder bereits kontaktiert sind, wobei auch die Kontaktflächen 50', 52' wieder vorzugsweise auf kürzest möglichem Weg über Verbindungsleitungen 44' mit der zweiten elektrischen Schaltungsmasse 30' verbunden sind.

Bei dem in Figur 3 gezeigten Ausführungsbeispiel, bei welchem auch dem korrespondierenden Steckverbinder 10' wenigstens ein ohmscher Widerstand 26', 28' bzw. eine zweite elektrische Schaltungsmasse 30' zugeordnet ist, wird davon ausgegangen, dass die erste elektrische Schaltungsmasse 30 des ersten Bauelements 40 dasselbe Potenzial wie die zweite elektrische Schaltungsmasse 30' auf dem zweiten Bauelement 40' aufweist. Zur Durchführung des Potenzialausgleichs kann vorgesehen sein, dass zumindest ein Kontaktelement des Steckverbinders 10 bzw. des korrespondierenden Steckverbinders 10' zur unmittelbaren Verbindung der ersten elektrischen Schaltungsmasse 30 und der zweiten elektrischen Schaltungsmasse 30' vorgesehen ist. Rein prinzipiell könnten die Potenziale der ersten und zweiten elektrischen Schaltungsmassen 30, 30' voneinander abweichen, jedoch sollten in der Praxis die Schaltungsmassen 30, 30' möglichst gleich sein.

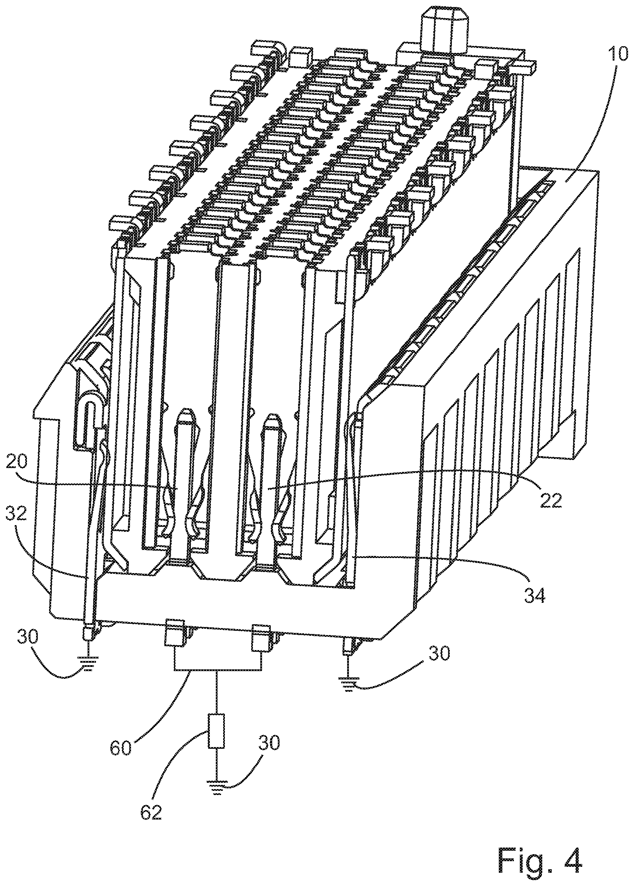

Figur 4 zeigt eine zu dem in Figur 2 gezeigten Ausführungsbeispiel alternative Ausführungsform, gemäß welcher zumindest zwei Abschirm-Kontaktelemente 20a, 20b unmittelbar mittels einer Verbindung 60 elektrisch miteinander verbunden sind, und wobei die elektrisch miteinander verbundenen Abschirm-Kontaktelemente 20a, 20b über einen einzigen ohmschen Widerstand 62 mit der ersten elektrischen Schaltungsmasse 30 verbunden sind. Die elektrische Verbindung 60 kann innerhalb des Steckverbinders 10 liegen. Alternativ kann die Verbindung 60 zwischen den wenigstens zwei Abschirm-Kontaktelementen 20a, 20b auf dem in Figur 4 nicht mehr gezeigten ersten Bauelement 40 vorgesehen sein. Ebenso kann der ohmsche Widerstand 62 zur Ankopplung der Verbindung 60 an die erste elektrische Schaltungsmasse 30 entweder noch im Steckverbinder 10, vorzugsweise jedoch auf dem ersten Bauelement 40 angeordnet sein.

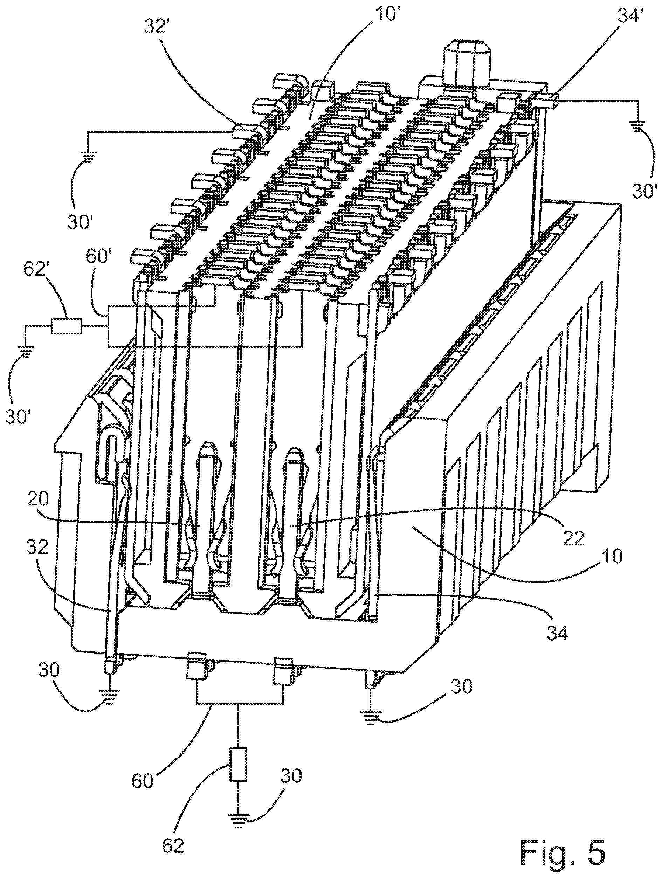

Figur 5 zeigt eine zu dem in Figur 3 gezeigten Ausführungsbeispiel alternative Ausführungsform, gemäß welcher zumindest zwei korrespondierende Abschirm-Kontaktelemente 20', 22' mittels einer Verbindung 60' unmittelbar elektrisch miteinander verbunden sind und wobei die direkt elektrisch miteinander verbundenen korrespondierenden Abschirm-Kontaktelemente 20', 22' über einen einzigen ohmschen Widerstand 62' mit der zweiten elektrischen Schaltungsmasse 30' verbunden sind.

Die elektrische Verbindung 60' kann innerhalb des korrespondierenden Steckverbinders 10' liegen. Alternativ kann die Verbindung 60' zwischen den wenigstens zwei Abschirm-Kontaktelementen 20', 22' auf dem in Figur 4 nicht mehr gezeigten zweiten Bauelement 40' vorgesehen sein. Ebenso kann der ohmsche Widerstand 62' zur Ankopplung der Verbindung 60' an die zweite elektrische Schaltungsmasse 30' entweder noch im korrespondierenden Steckverbinder 10', vorzugsweise jedoch auf dem zweiten Bauelement 40' angeordnet sein.

## Patentansprüche

1. Steckverbinder, der Kontaktelemente aufweist, die in wenigstens ein Signal-Kontaktelement (12, 18a, 18b) und wenigstens ein Abschirm-Kontaktelement (14, 20, 22) aufgeteilt sind, und ein erstes Bauelement (40) mit einer ersten elektrischen Schaltungsmasse (30), **dadurch gekennzeichnet, dass** ein ohmscher Widerstand (26, 28, 62) vorgesehen ist, der das Abschirm-Kontaktelement (14, 20, 22) mit der ersten elektrischen Schaltungsmasse (30) verbindet.

2. Steckverbindung nach Anspruch 1, **dadurch gekennzeichnet, dass** der Widerstandswert des ohmschen Widerstands (26, 28, 62) dem Wellenwiderstand einer über den Steckverbinder (10) geführten Signalleitung entspricht.

3. Steckverbindung nach Anspruch 1 oder 2, **dadurch gekennzeichnet, dass** der Widerstandswert des ohmschen Widerstands (26, 28, 62) im Bereich von 20 - 100 Ohm liegt.

4. Steckverbindung nach Anspruch 3, **dadurch gekennzeichnet, dass** der Widerstandswert des ohmschen Widerstands (26, 28, 62) wenigstens näherungsweise 50 Ohm beträgt.

5. Steckverbinder nach einem der vorhergehenden Ansprüche, **dadurch gekennzeichnet, dass** ein ohmscher Widerstand (26, 28, 62) jeweils genau einem Abschirm-Kontaktelement (14, 20, 22) zugeordnet ist.

6. Steckverbinder nach einem der Ansprüche 1 - 4, **dadurch gekennzeichnet, dass** ein ohmscher Widerstand (62) mehreren Abschirm-Kontaktelementen 20, 22) zugeordnet ist und dass die Abschirm-Kontaktelemente (20, 22) elektrisch unmittelbar miteinander verbunden sind.

7. Steckverbinder nach einem der vorhergehenden Ansprüche, **dadurch gekennzeichnet, dass** der Steckverbinder (10) eine Abschirmung (32, 34) aufweist und dass die Abschirmung (32, 34) zur Verbindung unmittelbar mit der ersten elektrischen Schaltungsmasse (30) vorgesehen ist.

8. Steckverbinder nach einem der vorhergehenden Ansprüche, **dadurch gekennzeichnet, dass** der wenigstens eine ohmsche Widerstand (26, 28, 62) im Steckverbinder (10) angeordnet ist.

9. Steckverbinder nach einem der Ansprüche 1 - 7, **dadurch gekennzeichnet, dass** der wenigstens eine ohmsche Widerstand (26, 28, 62) dem ersten Bauelement (40) zugeordnet ist.

10. Steckverbinder nach einem der vorhergehenden Ansprüche, **dadurch gekennzeichnet, dass** das erste Bauelement (40) eine Leiterplatte ist.

11. Steckverbinder nach Anspruch 10, **dadurch gekennzeichnet, dass** die Leiterplatte eine Multilayer-Leiterplatte ist und dass eine Ebene der Multilayer-Leiterplatte zumindest teilweise eine elektrisch leitfähige Fläche (42) mit dem Potenzial der ersten elektrischen Schaltungsmasse (30) aufweist.

12. Steckverbinder nach Anspruch 10 oder 11, **dadurch gekennzeichnet, dass** ein zum Steckverbinder (10) korrespondierender Steckverbinder (10') Kontaktelemente aufweist, die in wenigstens ein Signal-Kontaktelement (12, 18a', 18b') und wenigstens ein Abschirm-Kontaktelement (14', 20', 22') aufgeteilt sind, und ein zweites Bauelement (40') mit einer zweiten elektrischen Schaltungsmasse (30'), **dadurch gekennzeichnet dass** wenigstens ein korrespondierendes Abschirm-Kontaktelement (14', 20', 22') des korrespondierenden Steckverbinders (10') über einen elektrischen Widerstand (26' 28', 62') mit einer zweiten elektrischen Schaltungsmasse (30') verbunden ist.

13. Steckverbinder nach Anspruch 12, **dadurch gekennzeichnet, dass** bei miteinander kontaktierten Steckverbindern (10, 10') die erste elektrische Schaltungsmasse (30) und die zweite elektrische Schaltungsmasse (30') elektrisch unmittelbar miteinander verbunden sind.

14. Steckverbinder nach Anspruch 12 oder 13, **dadurch gekennzeichnet, dass** das zweite Bauelement (40') eine Backplane-Leiterplatte ist.

15. Verwendung des Steckverbinders (10) und des ersten Bauelements (40) nach einem der Ansprüche 1 - 11 und/oder des korrespondierenden Steckverbinders (10') und des zweiten Bauelements (40') nach Anspruch 12 oder 13, bei welcher benachbarte Kontaktelemente (18a, 18b, 18a', 18b') ein Signal-Kontaktelementpaar (16) bilden und bei welcher dem Signal-Kontaktelementpaar (16) wenigstens ein Abschirm-Kontaktelement (20, 22, 20', 22') zugeordnet ist.

16. Verwendung nach Anspruch 15, bei welcher das Signal-Kontaktelementpaar (16) differenzielle Signale führt.

## Claims

1. Plug connector that has contact elements that are divided into at least one signal contact element (12, 18a, 18b) and at least one shielding contact element (14, 20, 22), and a first component (40) having a first electrical circuit ground (30), **characterised in that** an ohmic resistor (26, 28, 62) is provided that connects the shielding contact element (14, 20, 22) to the first electrical circuit ground (30).

2. Plug connector according to claim 1, **characterised in that** the resistance value of the ohmic resistor (26, 28, 62) corresponds to the surge resistance of a signal wire guided across the plug connector (10).

3. Plug connector according to claim 1 or 2, **characterised in that** the resistance value of the ohmic resistor (26, 28, 62) ranges from 20 - 100 ohms.

4. Plug connector according to claim 3, **characterised in that** the resistance value of the ohmic resistor (26, 28, 62) amounts to at least approximately 50 ohms.

5. Plug connector according to one of the preceding claims, **characterised in that** the ohmic resistor (26, 28, 62) is in each case allocated exactly to a shielding contact element (14, 20, 22).

6. Plug connector according to one of claims 1 - 4, **characterised in that** an ohmic resistor (62) is allocated to several shielding contact elements (20, 22) and the shielding contact elements (20, 22) are directly electrically connected to one another.

7. Plug connector according to one of the preceding claims, **characterised in that** the plug connector (10) has a shielding (32, 34) and the shielding (32, 34) is provided to directly connect to the first electrical circuit ground (30).

8. Plug connector according to one of the preceding claims, **characterised in that** the at least one ohmic resistor (26, 28, 62) is arranged in the plug connector (10).

9. Plug connector according to one of claims 1 - 7, **characterised in that** the at least one ohmic resistor (26, 28, 62) is allocated to the first component (40).

10. Plug connector according to one of the preceding claims, **characterised in that** the first component (40) is a circuit board.

11. Plug connector according to claim 10, **characterised in that** the circuit board is a multi-layer circuit board and a layer of the multi-layer circuit board has at least partially an electrical conductive surface (42) having the potential of the first electrical circuit ground (30).

12. Plug connector according to claim 10 or 11, **characterised in that** a plug connector (10') corresponding to the plug connector (10) has contact elements that are divided into at least one signal contact element (12, 18a', 18b') and at least one shielding element (14', 20,' 22'), and a second component (40') having a second electrical circuit ground (30'), **characterised in that** at least one corresponding shielding contact element (14', 20', 22') of the corresponding plug connector (10') is connected to a second electrical circuit ground (30') via an electrical resistor (26', 28', 62').

13. Plug connector according to claim 12, **characterised in that**, with plug connectors contacting each other (10, 10'), the first electrical circuit ground (30) and the second electrical circuit ground (30') are directly electrically connected to each other.

14. Plug connector according to claim 12 or 13, **characterised in that** the second component (40') is a backplane circuit board.

15. Use of the plug connector (10) and of the first component (40) according to one of claims 1 - 11 and/or of the corresponding plug connector (10') and of the second component (49') according to claim 12 or 13, in which adjacent contact elements (18a, 18b, 18a', 18b') form a signal contact element pair (16) and in which at least one shielding contact element (20, 22, 20', 22') is allocated to the signal contact element pair (16).

16. Use according to claim 15, in which the signal contact element pair (16) guides differential signals.

## Revendications

1. Connecteur, qui comporte des éléments de contact, qui sont répartis en au moins un élément de contact de signal (12, 18a, 18b) et au moins un élément de contact de blindage (14, 20, 22), et un premier composant (40) avec une première masse de circuit électrique (30), **caractérisé en ce qu'**une résistance ohmique (26, 28, 62) est prévue, qui connecte l'élément de contact de blindage (14, 20, 22) à la première masse de circuit électrique (30).

2. Connecteur selon la revendication 1, **caractérisé en ce que** la valeur de résistance de la résistance ohmique (26, 28, 62) correspond à la résistance d'onde d'une ligne de signal guidée par le biais du connecteur (10).

3. Connecteur selon la revendication 1 ou 2, **caractérisé en ce que** la valeur de résistance de la résistance ohmique (26, 28, 62) se situe dans une plage allant de 20 à 100 ohms.

4. Connecteur selon la revendication 3, **caractérisé en ce que** la valeur de résistance de la résistance ohmique (26, 28, 62) s'élève au moins approximativement à 50 ohms.

5. Connecteur selon l'une des revendications précédentes, **caractérisé en ce qu'**une résistance ohmique (26, 28, 62) est associée respectivement exactement un élément de contact de blindage (14, 20, 22).

6. Connecteur selon l'une des revendications 1 à 4, **caractérisé en ce qu'**une résistance ohmique (62) est associée à plusieurs éléments de contact de blindage (20, 22) et **en ce que** les éléments de contact de blindage (20, 22) sont directement connectés électriquement entre eux.

7. Connecteur selon l'une des revendications précédentes, **caractérisé en ce que** le connecteur (10) présente un blindage (32, 34) et **en ce que** le blindage (32, 34) est prévu pour la connexion directe avec la première masse de circuit électrique (30).

8. Connecteur selon l'une des revendications précédentes, **caractérisé en ce que** l'au moins une résistance ohmique (26, 28, 62) est disposée dans le connecteur (10).

9. Connecteur selon l'une des revendications 1 à 7, **caractérisé en ce que** l'au moins une résistance ohmique (26, 28, 62) est associée au premier composant (40).

10. Connecteur selon l'une des revendications précédentes, **caractérisé en ce que** le premier composant (40) est une carte de circuit imprimé.

11. Connecteur selon la revendication 10, **caractérisé en ce que** la carte de circuit imprimé est une carte de circuit imprimé multicouche et **en ce qu'**un niveau de la carte de circuit imprimé multicouche présente au moins partiellement une surface électriquement conductrice (42) avec le potentiel de la première masse de circuit électrique (30).

12. Connecteur selon la revendication 10 ou 11, **caractérisé en ce qu'**un connecteur (10') correspondant au connecteur (10) comporte des éléments de contact, qui sont répartis en au moins un élément de contact de signal (12, 18a', 18b') et au moins un élément de contact de blindage (14', 20', 22'), et un deuxième composant (40') avec une deuxième masse de circuit électrique (30'), **caractérisé en ce qu'**au moins un élément de contact de blindage correspondant (14', 20', 22') du connecteur correspondant (10') est connecté à une deuxième masse de circuit électrique (30') par le biais d'une résistance électrique (26', 28', 62').

13. Connecteur selon la revendication 12, **caractérisé en ce que** pour des connecteurs en contact l'un avec l'autre (10, 10') la première masse de circuit électrique (30) et la deuxième masse de circuit électrique (30') sont directement connectées électriquement ensemble.

14. Connecteur selon la revendication 12 ou 13, **caractérisé en ce que** le deuxième composant (40') est une carte de circuit imprimé de fond de panier.

15. Utilisation du connecteur (10) et du premier composant (40) selon l'une des revendications 1 à 11 et/ou du connecteur correspondant (10') et du deuxième composant (40') selon la revendication 12 ou 13, dans laquelle des éléments de contact avoisinants (18a, 18b, 18a', 18b') créent une paire d'éléments de contact de signal (16) et dans laquelle au moins un élément de contact de blindage (20, 22, 20', 22') est associé à la paire d'éléments de contact de signal (16).

16. Utilisation selon la revendication 15, dans laquelle la paire d'éléments de contact de signal (16) transporte des signaux différentiels.
